# EUROPEAN PATENT APPLICATION

(11) **EP 4 672 903 A1**
(43) Date of publication of application: **31.12.2025**
(21) Application number: 25757711.4
(22) Date of filing: 18.02.2025
(51) Int. Cl.: H10D 30/83, H10D 30/01, H10D 62/10

(54) **SEMICONDUCTOR DEVICE AND MANUFACTURING METHOD THEREFOR**

(30) Priority: 19.02.2024 CN 202410184350
(71) Applicant: United Nova Technology -Yuezhou (Shaoxing) Corp., Shaoxing, Zhejiang 312000 (CN)
(72) Inventor: ZHAO, Liangliang, Shaoxing, Zhejiang 312000 (CN); LI, Yong, Shaoxing, Zhejiang 312000 (CN); SUN, Wei, Shaoxing, Zhejiang 312000 (CN)
(74) Representative: Kraus & Lederer PartGmbB
(86) International application number: PCT/CN2025/077830
(87) International publication number: WO 2025/176119

(57) **Abstract**

Provided are a semiconductor device and a preparation method therefor, the method including the following steps: providing a substrate and forming a drift region in the substrate; forming a plurality of channel isolation regions in the drift region, a space being defined between two adjacent ones of the channel isolation regions to form a channel region; and forming a source contact region, a drain contact region, and a gate contact region in the drift region, and forming a substrate contact region in the substrate, the substrate contact region being spaced apart from the drift region, the gate contact region being positioned between the source contact region and the drain contact region, and the channel region being in communication with the source contact region and the drain contact region. In the solutions of the present disclosure, a plurality of channel isolation regions are formed, with a space defined between two adjacent ones of the channel isolation regions to form a channel region. By adjusting the width of the channel region to regulate the pinch-off voltage of the device, a sufficiently high on-current of the device during conduction can be ensured, thereby reducing the on-resistance of the device, lowering the power consumption of the device, and enhancing the device performance.

## Description

### TECHNICAL FIELD

The present disclosure relates to the field of semiconductor technology, and in particular, to a semiconductor device and a preparation method therefor.

### BACKGROUND

With the continuous development of integrated circuits, various types of devices are often simultaneously fabricated on the same substrate to save space. For example, in the Bipolar-CMOS-DMOS (BCD) process, high-voltage power devices such as bipolar transistors, complementary metal-oxide-semiconductor (CMOS) devices, and diffused metal-oxide-semiconductor (DMOS) devices can be fabricated on the same substrate. The BCD process has been widely applied in various fields, including mobile devices, household appliances, displays, automobiles, and data centers.

The junction field-effect transistor (JFET), commonly used in the BCD process, features a very high input impedance, enabling strong isolation between input and output circuits. The JFET is free from the inherent noise associated with vacuum tubes and bipolar transistors. Moreover, the negative temperature coefficient thereof helps prevent the risk of thermal runaway. In addition, the JFET offers a very high power gain.

In the JFET, the pinch-off voltage is a critical parameter that plays a key role in regulating the source-to-drain current and in controlling the operating state of the JFET. However, in the related art, the pinch-off voltage of the JFET is generally not adjustable. Alternatively, although the pinch-off voltage can be adjusted, a low pinch-off voltage results in a reduced on-current in the JFET, which leads to an increased on-resistance of the JFET. This increased on-resistance further causes higher power consumption in practical applications, degrading device performance.

### SUMMARY

A series of simplified concepts is introduced in the Summary section, which are to be described in greater detail in the Detailed Description section. The summary of the present disclosure is not intended to define the key and essential technical features of the claimed technical solution, nor to determine the scope of protection of the claimed technical solution.

Aiming at the existing problems, one aspect of the present disclosure provides a semiconductor device, including:
a substrate having a first conductivity type;
a drift region extending from a first surface of the substrate into the substrate, the drift region having a second conductivity type;
a plurality of channel isolation regions located in the drift region and exposed to the first surface, a space being defined between two adjacent ones of the channel isolation regions to form a channel region, and the channel isolation regions having the first conductivity type;
a source contact region, a drain contact region, and a gate contact region located in the drift region, the gate contact region being positioned between the source contact region and the drain contact region, the channel region being in communication with the source contact region and the drain contact region, the source contact region and the drain contact region having the second conductivity type, and the gate contact region having the first conductivity type; and
a substrate contact region located in the substrate and spaced apart from the drift region, the substrate contact region having the first conductivity type.

In one embodiment, the drain contact region and the gate contact region form an annular structure, the gate contact region surrounds the outside of the source contact region, and the drain contact region surrounds the outside of the gate contact region; or,
the source contact region and the gate contact region form an annular structure, the gate contact region surrounds the outside of the drain contact region, and the source contact region surrounds the outside of the gate contact region.

In one embodiment, the semiconductor device further includes:
a first field oxide layer and a second field oxide layer located in the drift region, the first field oxide layer being positioned between the gate contact region and the drain contact region, and the second field oxide layer being positioned between the gate contact region and the source contact region; and
a first gate structure and a second gate structure, the first gate structure being located on the first field oxide layer and partially extending over the drift region, and the second gate structure being located on the first field oxide layer and positioned on a side of the first gate structure close to the drain contact region.

In one embodiment, the second gate structure is a floating gate structure.

In one embodiment, the semiconductor device further includes a source graded region and a drain graded region located in the drift region, the source contact region being located in the source graded region, the drain contact region being located in the drain graded region, and the source contact region and the drain contact region having the second conductivity type.

Another aspect of embodiments of the present disclosure provides a preparation method for a semiconductor device, the method including the following steps:
providing a substrate having a first conductivity type;
forming a drift region extending from a first surface of the substrate into the substrate, the drift region having a second conductivity type;
forming a plurality of channel isolation regions having the first conductivity type in the drift region, a space being defined between two adjacent ones of the channel isolation regions to form a channel region; and
forming a source contact region and a drain contact region having the second conductivity type and a gate contact region having the first conductivity type in the drift region, and forming a substrate contact region having the first conductivity type in the substrate, the substrate contact region being spaced apart from the drift region, the gate contact region being positioned between the source contact region and the drain contact region, and the channel region being in communication with the source contact region and the drain contact region.

In one embodiment, the drain contact region and the gate contact region form an annular structure, the gate contact region surrounds the outside of the source contact region, and the drain contact region surrounds the outside of the gate contact region; or,
the source contact region and the gate contact region form an annular structure, the gate contact region surrounds the outside of the drain contact region, and the source contact region surrounds the outside of the gate contact region.

In one embodiment, the method further includes the following steps:
forming a first field oxide layer and a second field oxide layer in the drift region, the first field oxide layer being positioned between the gate contact region and the drain contact region, and the second field oxide layer being positioned between the gate contact region and the source contact region; and
forming a first gate structure and a second gate structure, the first gate structure being located on the first field oxide layer and partially extending over the drift region, and the second gate structure being located on the first field oxide layer and positioned on a side of the first gate structure close to the drain contact region.

In one embodiment, the second gate structure is a floating gate structure.

In one embodiment, before the forming a source contact region and a drain contact region, the method further includes the following step:
forming a source graded region and a drain graded region having the second conductivity type in the drift region, the source contact region being located in the source graded region, and the drain contact region being located in the drain graded region.

In the semiconductor device and the preparation method thereof according to the embodiments of the present disclosure, a plurality of channel isolation regions are formed, with a space defined between two adjacent ones of the channel isolation regions to form a channel region. Each channel region can be pinched off from two directions. By adjusting the width of the channel region to regulate the pinch-off voltage of the device, a sufficiently high on-current of the device during conduction can be ensured, thereby reducing the on-resistance of the device, lowering the power consumption of the device, and enhancing the device performance.

### BRIEF DESCRIPTION OF THE DRAWINGS

The following drawings are incorporated herein as part of the present disclosure to facilitate the understanding of the present disclosure. The drawings illustrate embodiments of the present disclosure and the descriptions thereof, which are provided to explain the principles of the present disclosure.
FIG. 1 shows a flowchart of a preparation method for a semiconductor device according to a specific embodiment of the present disclosure.
FIG. 2A to FIG. 2J show schematic cross-sectional views of a semiconductor device obtained by sequentially implementing a preparation method for a semiconductor device according to a specific embodiment of the present disclosure.
FIG. 3 shows a schematic cross-sectional view of a semiconductor device obtained by sequentially implementing a preparation method for a semiconductor device according to another specific embodiment of the present disclosure.
FIG. 4 shows a schematic layout diagram of a semiconductor device obtained by sequentially implementing a preparation method for a semiconductor device according to a specific embodiment of the present disclosure.
FIG. 5 shows a schematic top view of a semiconductor device during pinch-off according to a specific embodiment of the present disclosure.
FIG. 6 shows a schematic top view of a semiconductor device during pinch-off according to another specific embodiment of the present disclosure.
FIG. 7 shows a schematic cross-sectional view of a semiconductor device during pinch-off according to a specific embodiment of the present disclosure.
FIG. 8 shows a schematic cross-sectional view of a semiconductor device according to another specific embodiment of the present disclosure.
FIG. 9 shows a schematic cross-sectional view of a semiconductor device during pinch-off according to another specific embodiment of the present disclosure.

### DETAILED DESCRIPTION

The present disclosure is described in more detail below with reference to the drawings, which show embodiments of the present disclosure. However, the present disclosure can be embodied in various forms and is not to be construed as being limited to the embodiments disclosed herein. Rather, the provision of these embodiments serves to make the disclosure thorough and complete, and to fully convey the scope of the present disclosure to those skilled in the art. In the drawings, the dimensions and relative proportions of layers and regions may be exaggerated for clarity. The same reference numerals denote the same elements throughout.

When an element or layer is referred to as being "on", "adjacent to", "connected to", or "coupled to" another element or layer, it may be directly on, adjacent to, connected to, or coupled to that element or layer, or intervening elements or layers may be present. Rather, when an element is referred to as being "directly on", "directly adjacent to", "directly connected to", or "directly coupled to" another element or layer, no intervening elements or layers are present. Although terms such as first, second, third may be used to describe various elements, components, regions, layers, and/or portions, these elements, components, regions, layers, and/or portions are not to be limited by these terms. These terms are merely used to distinguish one element, component, region, layer, or portion from another element, component, region, layer, or portion. Therefore, without departing from the teachings of the present disclosure, a first element, component, region, layer, or portion discussed below may be referred to as a second element, component, region, layer, or portion.

Spatial relational terms such as "beneath", "under", "below", "on", "over", and "above" may be used herein for convenience of description to describe the relationship between one element or feature shown in the drawings and another element or feature. In addition to the orientations shown in the drawings, the spatial relationship terms are intended to include different orientations of the device during use and operation. For example, if the device in the drawings is inverted, then an element or feature described as being "under", "beneath", or "below" another element or feature is to be oriented as being "above" the other element or feature. Therefore, the exemplary terms "under" and "beneath" may include upward and downward orientations. The devices may alternatively be oriented (rotated 90 degrees or in other orientations), and the spatial terms used herein are interpreted accordingly.

The terms used herein are solely to describe specific embodiments and are not intended to limit the present disclosure. As used herein, the singular forms "a/an", "one", and "the" are also intended to include the plural forms unless the context clearly indicates otherwise. The terms "comprise" and/or "include", when used in this specification, determine the presence of the features, integers, steps, operations, elements, and/or components, but do not preclude the presence or addition of one or more other features, integers, steps, operations, elements, components, and/or groups. As used herein, the term "and/or" includes any and all combinations of the relevant listed items.

The embodiments of the present disclosure are described herein with reference to schematic cross-sectional views of exemplary embodiments (and intermediate structures) of the present disclosure. In this way, variations from the shown shapes due to, for example, manufacturing technology and/or tolerances may be expected. Therefore, the embodiments of the present disclosure are not to be limited to the specific shapes of the regions shown herein, but also include shape deviations resulting from, for example, manufacturing. For example, an implantation region shown as rectangular typically has rounded or curved features at its edges and/or an implantation concentration gradient, rather than a binary transition from the implantation region to a non-implantation region. Similarly, a buried region formed by implantation may result in some implantation in the region between the buried region and the surface traversed during the implantation process. Therefore, the regions shown in the drawings are essentially schematic, and their shapes are not intended to represent the actual shapes of the regions in the display device, nor to limit the scope of the present disclosure.

Unless otherwise defined, all terms used herein (including technical and scientific terms) have the same meanings as commonly understood by those skilled in the art of the present disclosure. Terms, such as those commonly defined in ordinary dictionaries, are to be interpreted as having meanings consistent with their meaning in the relevant art and/or the context of this specification, and are not to be interpreted in an idealized or overly formal sense unless expressly defined otherwise herein.

For a thorough understanding of the present disclosure, detailed steps and structures are provided in the following description to illustrate the technical solutions proposed by the present disclosure. Exemplary embodiments of the present disclosure are described in detail below. However, the present disclosure may have other embodiments in addition to these embodiments described in detail herein.

In view of the above technical problems, the embodiments of the present disclosure provide a semiconductor device, including: a substrate having a first conductivity type;
a drift region extending from a first surface of the substrate into the substrate, the drift region having a second conductivity type;
a plurality of channel isolation regions located in the drift region and exposed to the first surface, a space being defined between two adjacent ones of the channel isolation regions to form a channel region, and the channel isolation regions having the first conductivity type;
a source contact region, a drain contact region, and a gate contact region located in the drift region, the gate contact region being positioned between the source contact region and the drain contact region, the channel region being in communication with the source contact region and the drain contact region, the source contact region and the drain contact region having the second conductivity type, and the gate contact region having the first conductivity type; and
a substrate contact region located in the substrate and spaced apart from the drift region, the substrate contact region having the first conductivity type.

The present disclosure further provides a preparation method for a semiconductor device, which mainly includes the following steps:
providing a substrate having a first conductivity type, and forming a drift region having a second conductivity type and extending from a first surface of the substrate into the substrate;
forming a plurality of channel isolation regions having the first conductivity type in the drift region, a space being defined between two adjacent ones of the channel isolation regions to form a channel region; and
forming a source contact region and a drain contact region having the second conductivity type and a gate contact region having the first conductivity type in the drift region, and forming a substrate contact region having the first conductivity type in the substrate, the substrate contact region extending from the first surface of the substrate into the substrate and being spaced apart from the drift region, the gate contact region being positioned between the source contact region and the drain contact region, and the channel region being in communication with the source contact region and the drain contact region.

In the semiconductor device and the preparation method thereof according to the embodiments of the present disclosure, a plurality of channel isolation regions are formed, with a space defined between two adjacent ones of the channel isolation regions to form a channel region. Each channel region is in communication with the source contact region and the drain contact region to form a current path. By adjusting the width of the channel region to regulate the pinch-off voltage of the device, a sufficiently high on-current of the device during conduction can be ensured, thereby reducing the on-resistance of the device, lowering the power consumption of the device, and enhancing the device performance.

### Embodiment 1

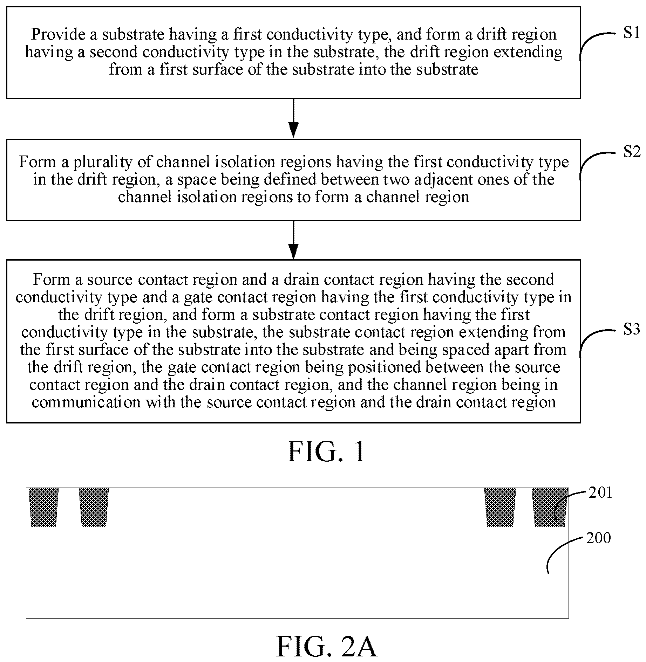

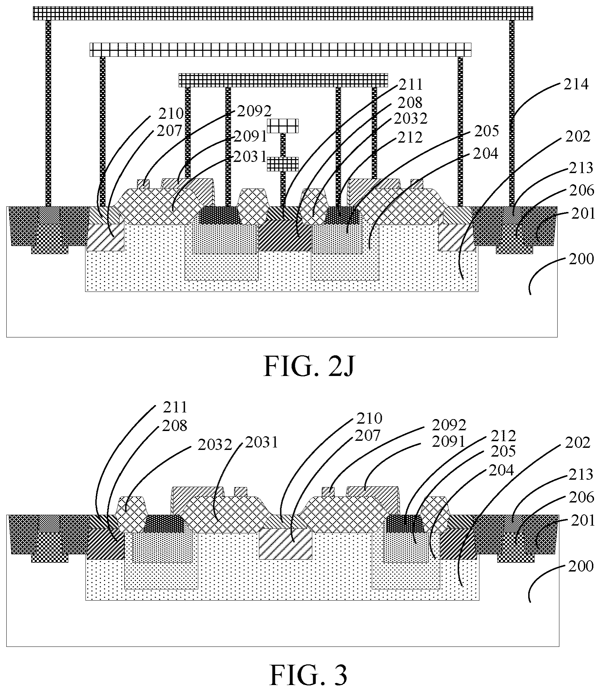

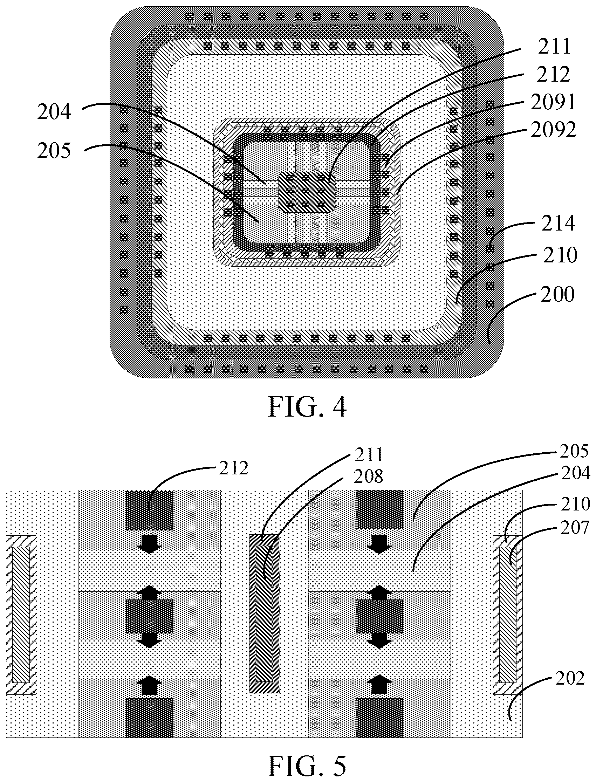

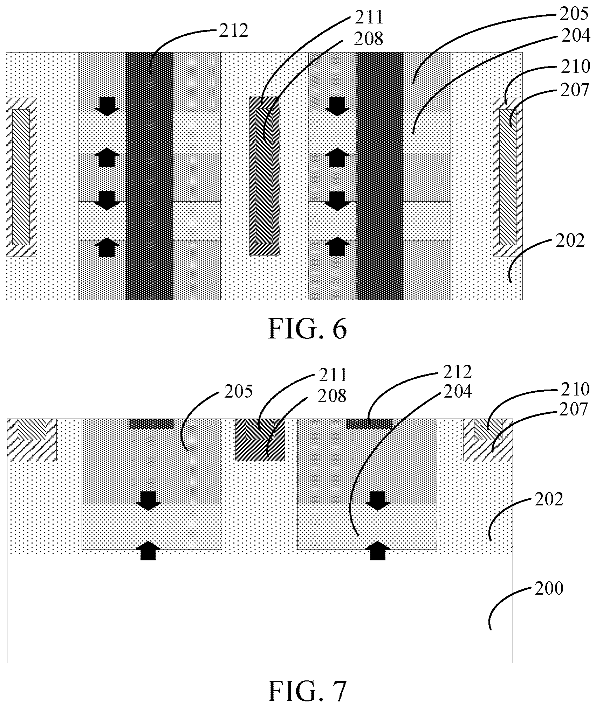

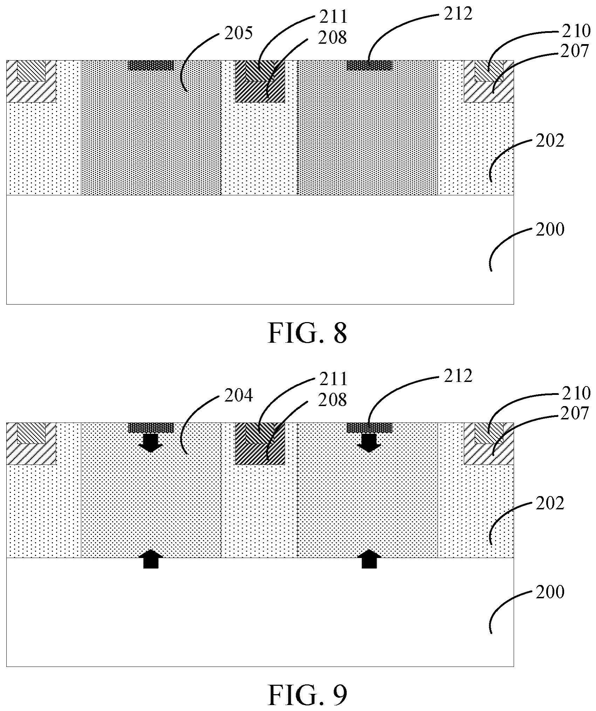

The preparation method for a semiconductor device of the present disclosure is described in detail below with reference to FIG. 1 to FIG. 9. FIG. 1 shows a flowchart of a preparation method for a semiconductor device according to a specific embodiment of the present disclosure. FIG. 2A to FIG. 2J show schematic cross-sectional views of a semiconductor device obtained by sequentially implementing a preparation method for a semiconductor device according to a specific embodiment of the present disclosure. FIG. 3 shows a schematic cross-sectional view of a semiconductor device obtained by sequentially implementing a preparation method for a semiconductor device according to another specific embodiment of the present disclosure. FIG. 4 shows a schematic layout diagram of a semiconductor device obtained by sequentially implementing a preparation method for a semiconductor device according to a specific embodiment of the present disclosure. FIG. 5 shows a schematic top view of a semiconductor device during pinch-off according to a specific embodiment of the present disclosure. FIG. 6 shows a schematic top view of a semiconductor device during pinch-off according to another specific embodiment of the present disclosure. FIG. 7 shows a schematic cross-sectional view of a semiconductor device during pinch-off according to a specific embodiment of the present disclosure. FIG. 8 shows a schematic cross-sectional view of a semiconductor device according to another specific embodiment of the present disclosure. FIG. 9 shows a schematic cross-sectional view of a semiconductor device during pinch-off according to another specific embodiment of the present disclosure.

Exemplarily, the preparation method for a semiconductor device according to the embodiments of the present disclosure includes the following steps:
First, S1 is performed, including providing a substrate having a first conductivity type; and forming a drift region having a second conductivity type and extending from a first surface of the substrate into the substrate.

Exemplarily, the semiconductor device of this application includes a JFET device. The semiconductor device may be any suitable device well known to those skilled in the art. In this embodiment, the technical solution of this application is illustrated and explained in an example where the semiconductor device is a JFET device.

In one example, as shown in FIG. 2A, the substrate 200 may include at least one of the following materials: Si, Ge, SiGe, SiC, SiGeC, InAs, GaAs, InP, InGaAs, or other III/V compound semiconductors. Alternatively, the substrate 200 may further include silicon-on-insulator (SOI), stacked silicon-on-insulator (SSOI), stacked silicon germanium-on-insulator (S-SiGeOI), silicon germanium-on-insulator (SiGeOI), germanium-on-insulator (GeOI), or the like. Although several examples of materials for forming the substrate 200 are described herein, any material that can serve as the substrate 200 falls within the spirit and scope of this application.

Exemplarily, the substrate 200 includes a semiconductor base and an epitaxial layer formed on the semiconductor base. In one embodiment, the semiconductor base and the epitaxial layer may have the same conductivity type. Exemplarily, the semiconductor base and the epitaxial layer may have different doping concentrations. For example, a doping concentration of the epitaxial layer may be lower than a doping concentration of the semiconductor base. Exemplarily, the substrate 200 has the first conductivity type, which may be N-type or P-type.

In one example, as shown in FIG. 2A, before forming a drift region 202, the method further includes the following step: forming a shallow trench isolation structure 201. Exemplarily, the forming a shallow trench isolation structure 201 may include the following steps: etching the substrate 200 to a specific depth from the first surface of the substrate 200 to form a shallow trench; and forming a silicon oxide layer in the shallow trench to form the shallow trench isolation structure 201. Exemplarily, the shallow trench isolation structure 201 is positioned between active regions of the device.

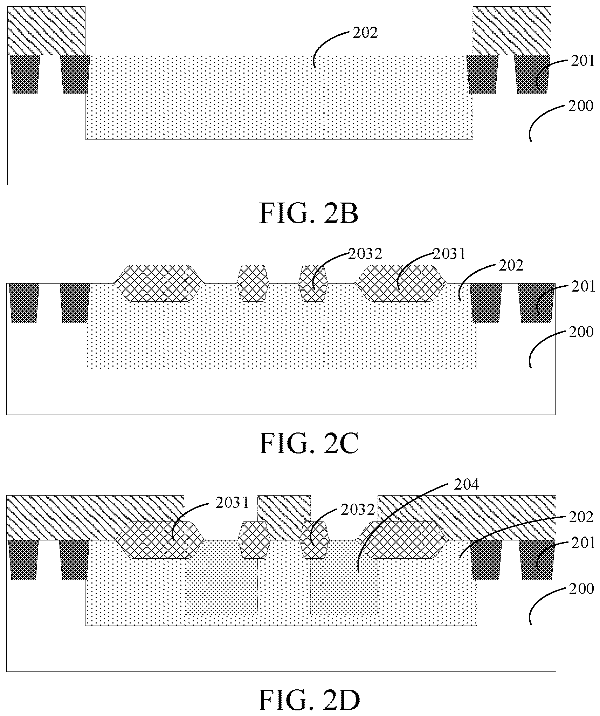

In one example, as shown in FIG. 2B, the drift region 202 having the second conductivity type and extending from the first surface of the substrate 200 into the substrate 200 is formed. Specifically, the drift region 202 may be formed by the following steps: forming a patterned mask layer on the first surface of the substrate 200; performing an ion implantation process using the mask layer as a mask to form the drift region 202; and finally removing the mask layer. Exemplarily, the mask layer includes a photoresist layer. Exemplarily, when the first conductivity type is P-type, the second conductivity type is N-type. When the first conductivity type is N-type, the second conductivity type is P-type. Exemplarily, the doping concentration of the drift region 202 is greater than the doping concentration of the substrate 200, thereby having a lower resistivity. Exemplarily, the drift region 202 is located within the active region of the device.

As shown in FIG. 2D, after forming a drift region 202 and before performing S2, the method of this application further includes the following step: forming a first implantation region 204 in the drift region 202, the first implantation region 204 having the second conductivity type. Specifically, the first implantation region 204 may be formed by the following steps: forming a patterned mask layer; performing an ion implantation process using the mask layer as a mask to form the first implantation region 204; and finally removing the mask layer. Exemplarily, the mask layer includes a photoresist layer. Exemplarily, the doping concentration of the first implantation region 204 is greater than the doping concentration of the drift region 202, which can further reduce the resistivity.

Next, S2 is performed, including forming a plurality of channel isolation regions having the first conductivity type in the drift region, a space being defined between two adjacent ones of the channel isolation regions to form a channel region.

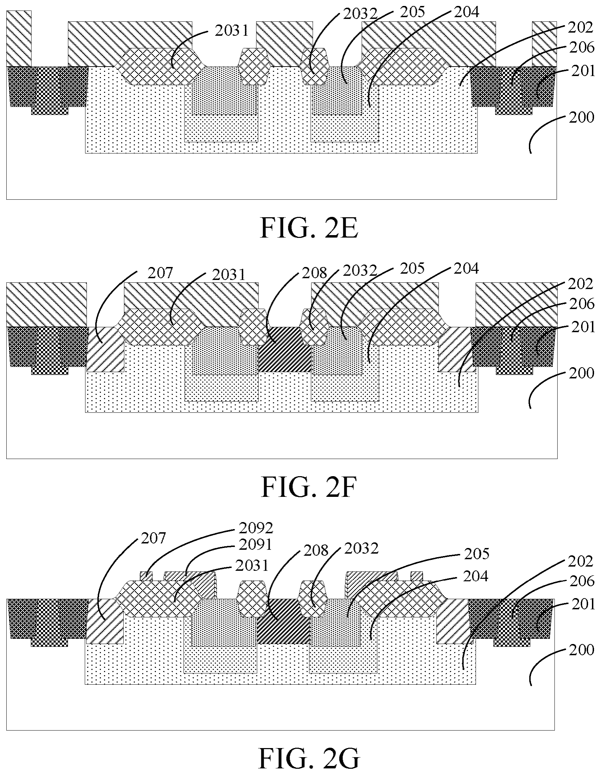

Specifically, as shown in FIG. 2E, FIG. 4, FIG. 5, and FIG. 6, the plurality of channel isolation regions 205 having the first conductivity type are formed in the drift region 202. The plurality of channel isolation regions 205 are exposed to the first surface of the substrate and spaced apart along the first surface of the substrate. A space is defined between two adjacent ones of the channel isolation regions 205 to form a channel region. When the first implantation region 204 is formed in the drift region 202, the space between two adjacent ones of the channel isolation regions 205 corresponds to the first implantation region 204; alternatively, the first implantation region 204 between two adjacent ones of the channel isolation regions 205 serves as the channel region.

In one example, as shown in FIG. 2E, the channel isolation region 205 may be formed by the following steps: forming a patterned mask layer; performing an ion implantation process using the mask layer as a mask to form the channel isolation region 205; and finally removing the mask layer. Exemplarily, the mask layer includes a photoresist layer.

In one example, as shown in FIG. 2E, FIG. 5, and FIG. 6, the depth of the channel isolation region 205 is smaller than the depth of the drift region 202. Furthermore, the depth of the channel isolation region 205 is smaller than the depth of the first implantation region 204. In this case, the first implantation region 204 and the drift region 202 between the channel isolation region 205 and the substrate 200 also serve as the channel region. In other examples, the depth of the channel isolation region 205 may be greater than or equal to the depth of the drift region 202. In this case, the channel region is positioned between two adjacent ones of the channel isolation regions 205.

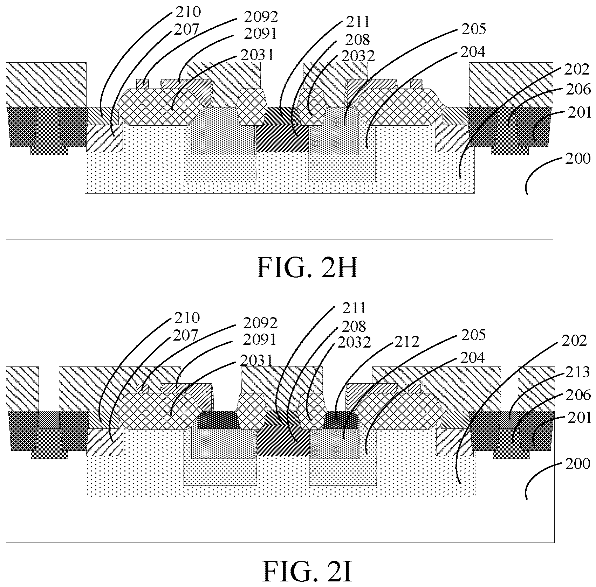

Next, S3 is performed. As shown in FIG. 2H, the source contact region 211 and the drain contact region 210, having the second conductivity type, are formed in the drift region, and the channel region is in communication with the source contact region 211 and the drain contact region 210. Specifically, the source contact region 211 and the drain contact region 210 may be formed by the following steps: forming a patterned mask layer; performing an ion implantation process using the mask layer as a mask to form the source contact region 211 and the drain contact region 210; and finally removing the mask layer. Exemplarily, the mask layer includes a photoresist layer.

As shown in FIG. 2I, a gate contact region 212 having the first conductivity type is formed in the drift region, and a substrate contact region 213 having the first conductivity type and extending from the first surface of the substrate 200 into the substrate 200 is formed in the substrate 200. The gate contact region 212 is positioned between the source contact region 211 and the drain contact region 210, and the substrate contact region 213 is spaced apart from the drift region 202. Specifically, the gate contact region 212 and the substrate contact region 213 may be formed by the following steps: forming a patterned mask layer; performing an ion implantation process using the mask layer as a mask to form the gate contact region 212 and the substrate contact region 213; and finally removing the mask layer. Exemplarily, the mask layer includes a photoresist layer. Exemplarily, the source contact region 211, the drain contact region 210, the gate contact region 212, and the substrate contact region 213 are heavily doped regions, which can effectively reduce contact resistance during subsequent electrical connection to a contact plug 214. Exemplarily, the substrate contact region 213 is positioned between the shallow trench isolation structures 201.

In one example, as shown in FIG. 2C and FIG. 2G, the method of this application further includes the following steps: forming a first field oxide layer 2031 and a second field oxide layer 2032 in the drift region 202, the first field oxide layer 2031 being positioned between the gate contact region 212 and the drain contact region 210, and the second field oxide layer 2032 being positioned between the gate contact region 212 and the source contact region 211; and forming a first gate structure 2091 and a second gate structure 2092, the first gate structure 2091 being located on the first field oxide layer 2031 and partially extending over the drift region 202, and the second gate structure 2092 being located on the first field oxide layer 2031 and positioned on a side of the first gate structure 2091 close to the drain contact region 210.

Exemplarily, any suitable method known to those skilled in the art may be employed to form the first field oxide layer 2031 and the second field oxide layer 2032. For example, the first field oxide layer 2031 and the second field oxide layer 2032 may be formed by thermal oxidation.

Exemplarily, the first gate structure 2091 and the second gate structure 2092 include a gate layer and sidewalls located on two sides of the gate layer. Exemplarily, the gate layer includes a polysilicon material, and generally, a metal, metal nitride, metal silicide, or a similar compound may be used as the material of the gate layer. Exemplarily, the material of the sidewall includes insulating materials such as silicon nitride, silicon oxide, or silicon oxynitride. The sidewall may be a single-layer structure or a multi-layer structure.

In one example, as shown in FIG. 2J, the gate contact region 212 and the first gate structure 2091 are electrically connected to the same external metal layer via the contact plug to form a gate. Specifically, the gate contact region 212 and the first gate structure 2091 are electrically connected via the contact plug, so that when a bias voltage is applied to the gate, the first gate structure 2091 can form a bias field plate structure with the first field oxide layer 2031. This increases the average electric field of the drift region 202 and reduces the peak electric field, thereby suppressing hot carrier effects and enhancing breakdown voltage. Exemplarily, the second gate structure 2092 is a floating gate structure. That is, the second gate structure 2092 does not require connection to an external electrode. The second gate structure 2092 can form a floating field plate structure with the first field oxide layer 2031, thereby making the electric field distribution in the drift region 202 more uniform and ensuring that corners with concentrated electric fields are less prone to breakdown, and further enhancing the breakdown voltage.

In one example, as shown in FIG. 2J, the contact plug 214 electrically connects the source contact region 211 to the external metal layer to form a source. The contact plug 214 also electrically connects the drain contact region 210 to the external metal layer to form a drain. Moreover, the contact plug 214 electrically connects the substrate contact region 213 to the external metal layer to lead out the substrate 200, thereby forming a substrate terminal. Exemplarily, the material of the contact plug 214 includes, but is not limited to, copper, tungsten, gold, silver, aluminum, and the like.

In one example, as shown in FIG. 2F, before the forming a source contact region 211 and a drain contact region 210, the method of this application further includes the following step: forming a source graded region 208 and a drain graded region 207 having the second conductivity type in the drift region 202, the source contact region 211 being located in the source graded region 208, and the drain contact region 210 being located in the drain graded region 207. Specifically, the source graded region 208 and the drain graded region 207 may be formed by the following steps: forming a patterned mask layer; performing an ion implantation process using the mask layer as a mask to form the source graded region 208 and the drain graded region 207; and finally removing the mask layer. Exemplarily, the mask layer includes a photoresist layer. Exemplarily, the doping concentration of the source graded region 208 is lower than the doping concentration of the source contact region 211, and the doping concentration of the drain graded region 207 is lower than the doping concentration of the drain contact region 210. By forming the source graded region 208 and the drain graded region 207, the electrostatic discharge robustness of the device can be enhanced, and excessive carrier concentration can be effectively changed, thereby effectively mitigating thermoelectric effects. Exemplarily, the first field oxide layer 2031 and the second field oxide layer 2032 may be formed first, followed by the formation of the source graded region 208 and the drain graded region 207, and then the formation of the first gate structure 2091 and the second gate structure 2092.

In one example, as shown in FIG. 2E, the method of this application further includes the following step: forming a second implantation region 206 in the substrate 200, the substrate contact region 213 being located in the second implantation region 206. Specifically, the second implantation region 206 may be formed by the following steps: forming a patterned mask layer; performing an ion implantation process using the mask layer as a mask to form the second implantation region 206; and finally removing the mask layer. Exemplarily, the mask layer includes a photoresist layer. Exemplarily, the second implantation region 206 has the first conductivity type.

In one example, as shown in FIG. 2J and FIG. 4, the drain contact region 210 and the gate contact region 212 form an annular structure, the gate contact region 212 surrounds the outside of the source contact region 211, and the drain contact region 210 surrounds the outside of the gate contact region 212. Alternatively, as shown in FIG. 3, the source contact region 211 and the gate contact region 212 form an annular structure, the gate contact region 212 surrounds the outside of the drain contact region 210, and the source contact region 211 surrounds the outside of the gate contact region 212. FIG. 3 shows a schematic cross-sectional view of a semiconductor device according to another embodiment of this application, capable of achieving the same functions as the semiconductor device illustrated in FIG. 2A to FIG. 2J. Such an overall annular enclosing structure can effectively reduce the device area. Exemplarily, in this case, the first gate structure 2091 and the second gate structure 2092 also form annular structures. Exemplarily, as shown in FIG. 5, the gate contact region 212 may be located in the channel isolation region 205, rather than in the first implantation region 204. In this case, the gate contact region 212 integrally forms a spaced annular structure.

In one example, after the above regions are formed by the ion implantation process, a rapid thermal annealing process is subsequently performed to activate the dopants in the ion-implanted regions and simultaneously repair the lattice structure damaged in the ion implantation process.

In one example, the pinch-off voltage of the device can be adjusted by regulating the width of the channel region between the channel isolation regions 205 to meet actual requirements.

In one example, as shown in FIG. 5, the gate contact region 212 may be located in the channel isolation region 205, rather than in the first implantation region 204. Alternatively, as shown in FIG. 6, the gate contact region 212 may be located in the channel isolation region 205 and the first implantation region 204.

In one example, as shown in FIG. 4, FIG. 5, and FIG. 6, in an example of the first conductivity type being P-type and the second conductivity type being N-type, when no reverse bias voltage is applied to the gate and the substrate terminal, the current can flow from the source to the drain through the channel regions between the channel isolation regions 205. Since the channel regions are formed between the channel isolation regions 205 in this application, a plurality of current paths can be formed. This ensures that the device can maintain a high on-current even at a low pinch-off voltage, thereby reducing the on-resistance of the device, lowering the power consumption of the device, and enhancing the device performance. When a reverse bias voltage is applied to the gate and the substrate terminal, the depletion layer between the channel isolation region 205 and the channel region gradually widens until the depletion layer completely fills the channel region. In this case, the channel region is pinched off, and the device is also in the pinch-off state. The arrows shown in FIG. 5 and FIG. 6 indicate the directions in which the depletion layer pinches off the channel region.

Exemplarily, as shown in FIG. 7, when the depth of the channel isolation region 205 is smaller than the depth of the drift region 202, a channel region can also be formed between the channel isolation region 205 and the substrate 200. A current path can also be formed in the channel region between the channel isolation region 205 and the substrate 200, thereby further enhancing the on-current of the device. The arrows in FIG. 7 indicate the directions in which the depletion layer pinches off the channel region between the channel isolation region 205 and the substrate 200. Exemplarily, as shown in FIG. 8, when the depth of the channel isolation region 205 is equal to or greater than the depth of the drift region 202, no channel region can be formed between the channel isolation region 205 and the substrate 200.

In addition, as shown in FIG. 9, when the gate contact region 212 is located in the channel isolation region 205 and the first implantation region 204, between adjacent channel isolation regions 205, the conductivity types of the gate contact region 212 and the substrate 200 are P-type, while the conductivity type of the first implantation region 204 therebetween is N-type. Therefore, a channel region can also be formed between the gate contact region 212 and the substrate 200. Specifically, a channel region can be formed in the first implantation region 204 between the gate contact region 212 and the substrate 200. The channel region between the gate contact region 212 and the substrate 200 can be pinched off simultaneously by the gate contact region 212, the substrate 200, and the channel isolation regions 205 on two sides of the first implantation region 204. The arrows in FIG. 9 indicate the directions in which the depletion layer pinches off the channel region between the gate contact region 212 and the substrate 200.

The description of the key steps of the preparation method for a semiconductor device of the present disclosure has been completed. The preparation of a complete semiconductor device may include additional steps, which are not described in detail herein. The sequence of the above steps may be adjusted, provided that no conflict arises.

In summary, in the preparation method for a semiconductor device according to the embodiments of the present disclosure, a plurality of channel isolation regions are formed, with a space between two adjacent ones of the channel isolation regions to form a channel region. Each channel region is in communication with the source contact region and the drain contact region to form a current path, that is, a plurality of current paths can be formed. By adjusting the width of the channel region to regulate the pinch-off voltage of the device, a sufficiently high on-current of the device during conduction can be ensured, thereby reducing the on-resistance of the device, lowering the power consumption of the device, and enhancing the device performance. Exemplarily, when the depth of the channel isolation region is smaller than the depth of the drift region, a channel region is also formed between the channel isolation region and the substrate, which enables the formation of a current path and further enhances the on-current of the device. Exemplarily, the drain contact region and the gate contact region form an annular structure, the gate contact region surrounds the outside of the source contact region, and the drain contact region surrounds the outside of the gate contact region. Alternatively, the source contact region and the gate contact region form an annular structure, the gate contact region surrounds the outside of the drain contact region, and the source contact region surrounds the outside of the gate contact region. Such an annular enclosing structure can effectively reduce the device area. Exemplarily, the second gate structure can form a bias field plate structure with the first field oxide layer. This increases the average electric field of the drift region and reduces the peak electric field, thereby suppressing hot carrier effects and enhancing breakdown voltage. The second gate structure can form a floating field plate structure with the first field oxide layer, thereby making the electric field distribution in the drift region more uniform and ensuring that corners with concentrated electric fields are less prone to breakdown, and further enhancing the breakdown voltage.

### Embodiment 2

The present disclosure further provides a semiconductor device, which can be prepared by the method described in Embodiment 1. Specifically, as shown in FIG. 2J, the semiconductor device includes:
a substrate 200 having a first conductivity type;
a drift region 202 extending from a first surface of the substrate 200 into the substrate 200, the drift region 202 having a second conductivity type;
a plurality of channel isolation regions 205 located in the drift region 202 and exposed to the first surface of the substrate, a space being defined between two adjacent ones of the channel isolation regions 205 to form a channel region, and the channel isolation regions 205 having the first conductivity type;
a source contact region 211, a drain contact region 210, and a gate contact region 212 located in the drift region 202, the gate contact region 212 being positioned between the source contact region 211 and the drain contact region 210, the channel region being in communication with the source contact region 211 and the drain contact region 210, the source contact region 211 and the drain contact region 210 having the second conductivity type, and the gate contact region 212 having the first conductivity type; and
a substrate contact region 213 extending from the first surface of the substrate 200 into the substrate 200 and spaced apart from the drift region 202, the substrate contact region 213 having the first conductivity type.

Exemplarily, the substrate 200 may include at least one of the following materials: Si, Ge, SiGe, SiC, SiGeC, InAs, GaAs, InP, InGaAs, or other III/V compound semiconductors. Alternatively, the substrate 200 may further include SOI, SSOI, S-SiGeOI, SiGeOI, GeOI, or the like. Although several examples of materials for forming the substrate 200 are described herein, any material that can serve as the substrate 200 falls within the spirit and scope of this application.

Exemplarily, the first conductivity type may be N-type, while the second conductivity type may be P-type. Alternatively, the first conductivity type may be P-type, while the second conductivity type may be N-type.

In one example, as shown in FIG. 2J, the semiconductor device of this application further includes the first implantation region 204 located in the drift region 202, the first implantation region 204 having the second conductivity type. Exemplarily, when the first implantation region 204 is formed in the drift region 202, the space between two adjacent ones of the channel isolation regions 205 corresponds to the first implantation region 204. Alternatively, the first implantation region 204 between two adjacent ones of the channel isolation regions 205 serves as the channel region.

In one example, the depth of the channel isolation region 205 is smaller than the depth of the drift region 202. Furthermore, the depth of the channel isolation region 205 is smaller than the depth of the first implantation region 204. In this case, the first implantation region 204 and the drift region 202 between the channel isolation region 205 and the substrate 200 also serve as the channel region. In other examples, the depth of the channel isolation region 205 may be greater than or equal to the depth of the drift region 202.

In one example, the semiconductor device of this application further includes a shallow trench isolation structure 201, which is positioned between active regions of the device. Exemplarily, the substrate contact region 213 is positioned between the shallow trench isolation structures 201. Exemplarily, the drift region 202 is located within the active region of the device.

In one example, the semiconductor device of this application further includes a first field oxide layer 2031 and a second field oxide layer 2032 located in the drift region 202, the first field oxide layer 2031 being positioned between the gate contact region 212 and the drain contact region 210, and the second field oxide layer 2032 being positioned between the gate contact region 212 and the source contact region 211. Moreover, the semiconductor device of this application further includes a first gate structure 2091 and a second gate structure 2092, the first gate structure 2091 being located on the first field oxide layer 2031 and partially extending over the drift region 202, and the second gate structure 2092 being located on the first field oxide layer 2031 and positioned on a side of the first gate structure 2091 close to the drain contact region 210.

In one example, the first gate structure 2091 and the second gate structure 2092 include a gate layer and sidewalls located on two sides of the gate layer.

In one example, the gate contact region 212 and the first gate structure 2091 are electrically connected to the same external metal layer via the contact plug to form a gate. Specifically, the gate contact region 212 and the first gate structure 2091 are electrically connected via the contact plug, so that when a bias voltage is applied to the gate, the first gate structure 2091 can form a bias field plate structure with the first field oxide layer 2031. This increases the average electric field of the drift region 202 and reduces the peak electric field, thereby suppressing hot carrier effects and enhancing breakdown voltage. Exemplarily, the second gate structure 2092 is a floating gate structure. That is, the second gate structure 2092 does not require connection to an external electrode. The second gate structure 2092 can form a floating field plate structure with the first field oxide layer 2031, thereby making the electric field distribution in the drift region 202 more uniform and ensuring that corners with concentrated electric fields are less prone to breakdown, and further enhancing the breakdown voltage.

In one example, as shown in FIG. 2J, the contact plug 214 electrically connects the source contact region 211 to the external metal layer to form a source. The contact plug 214 also electrically connects the drain contact region 210 to the external metal layer to form a drain. Moreover, the contact plug 214 electrically connects the substrate contact region 213 to the external metal layer to lead out the substrate 200, thereby forming a substrate terminal. Exemplarily, the material of the contact plug 214 includes, but is not limited to, copper, tungsten, gold, silver, aluminum, and the like.

In one example, as shown in FIG. 2F, the semiconductor device of this application further includes a source graded region 208 and a drain graded region 207 located in the drift region 202. The source contact region 211 is located in the source graded region 208, and the drain contact region 210 is located in the drain graded region 207. The source graded region 208 and the drain graded region 207 have the second conductivity type. Exemplarily, the doping concentration of the source graded region 208 is lower than the doping concentration of the source contact region 211, and the doping concentration of the drain graded region 207 is lower than the doping concentration of the drain contact region 210. By forming the source graded region 208 and the drain graded region 207, the electrostatic discharge robustness of the device can be enhanced, and excessive carrier concentration can be effectively changed, thereby effectively mitigating thermoelectric effects.

In one example, as shown in FIG. 2E, the semiconductor device of this application further includes a second implantation region 206. The substrate contact region 213 is located in the second implantation region 206, and the second implantation region 206 has the first conductivity type.

In one example, as shown in FIG. 2J and FIG. 4, the drain contact region 210 and the gate contact region 212 form an annular structure, the gate contact region 212 surrounds the outside of the source contact region 211, and the drain contact region 210 surrounds the outside of the gate contact region 212. Alternatively, as shown in FIG. 3, the source contact region 211 and the gate contact region 212 form an annular structure, the gate contact region 212 surrounds the outside of the drain contact region 210, and the source contact region 211 surrounds the outside of the gate contact region 212. FIG. 3 shows a schematic cross-sectional view of a semiconductor device according to another embodiment of this application, capable of achieving the same functions as the semiconductor device illustrated in FIG. 2A to FIG. 2J. Such an overall annular enclosing structure can effectively reduce the device area. Exemplarily, in this case, the first gate structure 2091 and the second gate structure 2092 also form annular structures. Exemplarily, as shown in FIG. 5, the gate contact region 212 may be located in the channel isolation region 205, rather than in the first implantation region 204. In this case, the gate contact region 212 integrally forms a spaced annular structure.

In one example, the pinch-off voltage of the device can be adjusted by regulating the width of the channel region between the channel isolation regions 205 to meet actual requirements.

In one example, as shown in FIG. 5, the gate contact region 212 may be located in the channel isolation region 205, rather than in the first implantation region 204. Alternatively, as shown in FIG. 6, the gate contact region 212 may be located in the channel isolation region 205 and the first implantation region 204.

In one example, as shown in FIG. 4, FIG. 5, and FIG. 6, in an example of the first conductivity type being P-type and the second conductivity type being N-type, when no reverse bias voltage is applied to the gate and the substrate terminal, the current can flow from the source to the drain through the channel regions between the channel isolation regions 205. Since the channel regions are formed between the channel isolation regions 205 in this application, a plurality of current paths can be formed. This ensures that the device can maintain a high on-current even at a low pinch-off voltage, thereby reducing the on-resistance of the device, lowering the power consumption of the device, and enhancing the device performance. When a reverse bias voltage is applied to the gate and the substrate terminal, the depletion layer between the channel isolation region 205 and the channel region gradually widens until the depletion layer completely fills the channel region. In this case, the channel region is pinched off, and the device is also in the pinch-off state. The arrows shown in FIG. 5 and FIG. 6 indicate the directions in which the depletion layer pinches off the channel region.

Exemplarily, as shown in FIG. 7, when the depth of the channel isolation region 205 is smaller than the depth of the drift region 202, a channel region can also be formed between the channel isolation region 205 and the substrate 200. A current path can also be formed in the channel region between the channel isolation region 205 and the substrate 200, thereby further enhancing the on-current of the device. The arrows in FIG. 7 indicate the directions in which the depletion layer pinches off the channel region between the channel isolation region 205 and the substrate 200. Exemplarily, as shown in FIG. 8, when the depth of the channel isolation region 205 is equal to or greater than the depth of the drift region 202, no channel region can be formed between the channel isolation region 205 and the substrate 200.

In addition, as shown in FIG. 9, when the gate contact region 212 is located in the channel isolation region 205 and the first implantation region 204, between adjacent channel isolation regions 205, the conductivity types of the gate contact region 212 and the substrate 200 are P-type, while the conductivity type of the first implantation region 204 therebetween is N-type. Therefore, a channel region can also be formed between the gate contact region 212 and the substrate 200. Specifically, a channel region can be formed in the first implantation region 204 between the gate contact region 212 and the substrate 200. The channel region between the gate contact region 212 and the substrate 200 can be pinched off simultaneously by the gate contact region 212, the substrate 200, and the channel isolation regions 205 on two sides of the first implantation region 204. The arrows in FIG. 9 indicate the directions in which the depletion layer pinches off the channel region between the gate contact region 212 and the substrate 200.

Exemplarily, the semiconductor device of this application includes a JFET device. The semiconductor device may be any suitable device well known to those skilled in the art. In this embodiment, the technical solution of this application is illustrated and explained in an example where the semiconductor device is a JFET device.

The description of the structure of the semiconductor device of the present disclosure has been completed. The complete device may include other constituent structures, which are not described in detail herein.

### Embodiment 3

Another embodiment of the present disclosure further provides an electronic apparatus, which includes the above semiconductor device.

The electronic apparatus of this embodiment may be any electronic product or device, such as a mobile phone, tablet, laptop, netbook, game console, television, VCD, DVD, navigation device, camera, video camera, voice recorder, MP3, MP4, or PSP. The electronic apparatus may be any intermediate product including the semiconductor device. The electronic apparatus according to the embodiments of the present disclosure has improved performance due to the use of the above semiconductor device.

Although various embodiments have been described herein, those skilled in the art may conceive of various other modifications and embodiments, all of which fall within the spirit and scope of the present disclosure. More particularly, within the scope of the present disclosure, the drawings, and the appended claims, various modifications and changes may be made to the combinations, arrangements, and/or components of the subject matter. In addition to modifications and changes to the components and/or arrangements, the use of alternative approaches is apparent to those skilled in the art.

## Claims

1. A semiconductor device, comprising:
a substrate having a first conductivity type;
a drift region extending from a first surface of the substrate into the substrate, the drift region having a second conductivity type;
a plurality of channel isolation regions located in the drift region and exposed to the first surface, a space being defined between two adjacent ones of the channel isolation regions to form a channel region, and the channel isolation regions having the first conductivity type;
a source contact region, a drain contact region, and a gate contact region located in the drift region, the gate contact region being positioned between the source contact region and the drain contact region, the channel region being in communication with the source contact region and the drain contact region, the source contact region and the drain contact region having the second conductivity type, and the gate contact region having the first conductivity type; and
a substrate contact region located in the substrate and spaced apart from the drift region, the substrate contact region having the first conductivity type.

2. The semiconductor device according to claim 1, wherein the drain contact region and the gate contact region form an annular structure, the gate contact region surrounds the outside of the source contact region, and the drain contact region surrounds the outside of the gate contact region; or
the source contact region and the gate contact region form an annular structure, the gate contact region surrounds the outside of the drain contact region, and the source contact region surrounds the outside of the gate contact region.

3. The semiconductor device according to claim 1, further comprising:
a first field oxide layer and a second field oxide layer located in the drift region, the first field oxide layer being positioned between the gate contact region and the drain contact region, and the second field oxide layer being positioned between the gate contact region and the source contact region; and
a first gate structure and a second gate structure, the first gate structure being located on the first field oxide layer and partially extending over the drift region, and the second gate structure being located on the first field oxide layer and positioned on a side of the first gate structure close to the drain contact region.

4. The semiconductor device according to claim 3, wherein the second gate structure is a floating gate structure.

5. The semiconductor device according to claim 1, further comprising a source graded region and a drain graded region located in the drift region, the source contact region being located in the source graded region, the drain contact region being located in the drain graded region, and the source contact region and the drain contact region having the second conductivity type.

6. A preparation method for a semiconductor device, the method comprising the following steps:
providing a substrate having a first conductivity type;
forming a drift region extending from a first surface of the substrate into the substrate, the drift region having a second conductivity type;
forming a plurality of channel isolation regions having the first conductivity type in the drift region, a space being defined between two adjacent ones of the channel isolation regions to form a channel region; and
forming a source contact region and a drain contact region having the second conductivity type and a gate contact region having the first conductivity type in the drift region, and forming a substrate contact region having the first conductivity type in the substrate, the substrate contact region being spaced apart from the drift region, the gate contact region being positioned between the source contact region and the drain contact region, and the channel region being in communication with the source contact region and the drain contact region.

7. The preparation method according to claim 6, wherein the drain contact region and the gate contact region form an annular structure, the gate contact region surrounds the outside of the source contact region, and the drain contact region surrounds the outside of the gate contact region; or
the source contact region and the gate contact region form an annular structure, the gate contact region surrounds the outside of the drain contact region, and the source contact region surrounds the outside of the gate contact region.

8. The preparation method according to claim 6, further comprising the following steps:
forming a first field oxide layer and a second field oxide layer in the drift region, the first field oxide layer being positioned between the gate contact region and the drain contact region, and the second field oxide layer being positioned between the gate contact region and the source contact region; and
forming a first gate structure and a second gate structure, the first gate structure being located on the first field oxide layer and partially extending over the drift region, and the second gate structure being located on the first field oxide layer and positioned on a side of the first gate structure close to the drain contact region.

9. The preparation method according to claim 8, wherein the second gate structure is a floating gate structure.

10. The preparation method according to claim 6, wherein before the forming a source contact region and a drain contact region, the method further comprises the following step:
forming a source graded region and a drain graded region having the second conductivity type in the drift region, the source contact region being located in the source graded region, and the drain contact region being located in the drain graded region.
